(19) Europäisches Patentamt
European Patent Office
Office européen des brevets

(11)  **EP 3 879 284 B1**

(12)  **EUROPEAN PATENT SPECIFICATION**

(45) Date of publication and mention
of the grant of the patent:
**05.06.2024 Bulletin 2024/23**

(21) Application number: **20163138.9**

(22) Date of filing: **13.03.2020**

(51) International Patent Classification (IPC):
*G01R 31/12* (2020.01)     *G01R 31/327* (2006.01)
*H01H 33/26* (2006.01)     *H02B 13/065* (2006.01)

(52) Cooperative Patent Classification (CPC):
**G01R 31/1254; G01R 31/1272; G01R 31/3275;
H01H 33/26;** H02B 13/065

(54)  **FAULT LOCALIZATION SYSTEM AND ASSOCIATED FAULT LOCALIZATION METHOD**

FEHLERLOKALISIERUNGSSYSTEM UND ZUGEHÖRIGES
FEHLERLOKALISIERUNGSVERFAHREN

SYSTÈME DE LOCALISATION DE DÉFAUTS ET PROCÉDÉ DE LOCALISATION DE DÉFAUTS
ASSOCIÉS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.09.2021 Bulletin 2021/37**

(73) Proprietor: **General Electric Technology GmbH
5400 Baden (CH)**

(72) Inventor: **VUACHET, Jacques
73100 Aix-les-Bains (FR)**

(74) Representative: **Brevalex
Tour Trinity
1 B Place de la Défense
92400 Courbevoie (FR)**

(56) References cited:
**EP-A2- 1 024 573     CN-B- 107 390 100
FR-A1- 3 040 781     KR-A- 20130 047 418
US-A- 6 014 083     US-A1- 2014 300 370**

- **HE SHAO-YIN ET AL: "Norm Criteria in the
Electromagnetic Time Reversal Technique for
Fault Location in Transmission Lines", IEEE
TRANSACTIONS ON ELECTROMAGNETIC
COMPATIBILITY, IEEE SERVICE CENTER, NEW
YORK, NY, US, vol. 60, no. 5, 1 October 2018
(2018-10-01), pages 1240-1248, XP011687087,
ISSN: 0018-9375, DOI:
10.1109/TEMC.2018.2806892 [retrieved on
2018-07-13]**

**Description**

**TECHNICAL FIELD**

The invention concerns a fault localization system for locating a fault in a gas-insulated switchgear. The invention also concerns an assembly comprising such a fault localization system, and a fault localization method.

The invention applies to the field of electric power transmission, and more particularly to the maintenance of gas-insulated switchgear and substations (GIS).

**BACKGROUND ART**

Commissioning and maintenance of gas-insulated substations must be fast in order to be cost-effective. To fulfill such a requirement, detection, identification and localization of faults in a gas-insulated switchgear must be fast reliable and, foremost, accurate. Indeed, localization errors (even of a few tens of centimeters) would lead to consignment and dismounting of unfaulty GIS sections, which would be very detrimental from a time and cost perspective.

When such defects are partial discharges, it is known to determine their location using a time of flight method.

For implementing such a method, a plurality of installed antennas within the GIS (that is to say within the metal sheet housing the insulating gas) are used. When a partial discharge occurs, such a discharges generates electromagnetic waves, generally in the ultra-high frequency band (that is in the range between 300 megahertz and 3 gigahertz).

Based on the time of arrival of these electromagnetic waves at each antenna, a location of the partial discharge is estimated.

However, such a method is not satisfactory.

Indeed, a gas-insulated switchgear is a very complex wave guide. As a result, before reaching each of the aforementioned antennas, the electromagnetic waves originating from a partial discharge undergo reflections, refractions with medium changes (gas/insulator/gas) and diffractions which change the path of each wave and create interferences and echoes that alter their amplitude and phase. As a result, the first antenna to receive a wave originating from the partial discharge is not necessarily the closest to said partial discharge. This is particularly detrimental to the accuracy of the time of flight method, which, when applied to GIS, may entail localization errors of several hundred percent.

US2014/300370A1 and HE SHAO-YIN ET AL. : "Norm Criteria in the Electromagnetic Time Reversal Technique for Fault Location in Transmission Lines", IEEE TRANSACTIONS ON ELECTROMAGNETIC COMPATIBILITY, vol. 60, no. 5, 1 October 2018, pages 1240-1248 both disclose methods and devices for fault location in transmission lines. US6,014,083A discloses partial discharge detection in a switchgear assembly.

A purpose of the invention is to provide a fault localization system that is fast, cheap and reliable.

**SUMMARY OF THE INVENTION**

To this end, the present invention is a fault localization system according to claim 1, comprising at least one transceiver and a controller connected to each transceiver,

each transceiver being meant to be arranged within the gas-insulated switchgear, each transceiver being configured to output a detection signal corresponding to a received electromagnetic wave, preferably generated by the fault;
the controller being configured, for each transceiver, to compute a time reversed signal by performing time reversal based on the corresponding detection signal, and to input, to the transceiver, an associated probe signal that is dependent on the corresponding time reversed signal;
each transceiver being further configured to radiate, at an emission time, a probe electromagnetic wave based on the corresponding probe signal, and to output a response signal associated to a response electromagnetic wave corresponding to a response of the environment of the transceiver to the probe electromagnetic wave, and received at a reception time, the controller being further configured to determine information relating to the location of the fault based on a time difference between the emission time and the reception time.

Indeed, because the probe signal is generated based on a time reversed version of the detection signal, the probe electromagnetic wave radiated by the corresponding transceiver focuses at the same location as the fault which has generated the respective fault-generated electromagnetic wave received by said transceiver. Then, from the location of the fault, the probe electromagnetic wave propagates as the aforementioned response electromagnetic wave back to the transceiver.

The distance between the transceiver and the location of the fault is therefore easily obtained from the back and forth duration, which leads to an enhanced accuracy in the fault localization. This drastically saves intervention and down-time cost during switchgear commissioning or maintenance.

Moreover, the claimed fault localization system is able to operate using a single transceiver, which makes its simpler to implement than the known fault localization systems that require several antennas.

Furthermore, when the fault localization system comprises two transceivers or more, propagation speed estimation of the involved electromagnetic waves can be performed based on the well-known distances between the transceivers, which further improves accuracy.

According to other advantageous aspects of the invention, the fault localization system includes one or more of the following features, taken alone or in any possible combination:

- the controller is configured to determine a distance of the fault from each transceiver as:

$$D = \frac{v}{2}\left(t_r - t_e - \tau_s\right)$$

wherein D is the distance of the fault from the transceiver;
v is a propagation speed of the probe electromagnetic wave and the response electromagnetic wave in the environment of the transceiver;
$t_e$ is the emission time corresponding to the transceiver;
$t_r$ is the reception time corresponding to the transceiver; and
$\tau_s$ is a duration of the probe signal;

- for each transceiver, the controller is configured to generate the corresponding probe signal by amplifying the corresponding time reversed signal;
- for each transceiver, in order to perform time reversal based on the corresponding detection signal, the controller is configured:

  • to generate an intermediate signal by amplifying a predetermined frequency of the detection signal and/or modulating a coda on the predetermined frequency of the detection signal; and
  • to compute the time reversed signal as a time reversed version of the generated intermediate signal,

  the controller being further configured to determine the reception time as a time at which the predetermined frequency is first detected in the response signal;
- for each transceiver, the controller is configured to compute a plurality of time reversed signals, each depending on a corresponding intermediate signal generated based on a respective predetermined frequency, the controller being further configured to estimate, for each predetermined frequency, a value of the distance of the fault from the transceiver based on the time difference between the emission time and the reception time corresponding to the predetermined frequency, the controller being also configured to determine the distance of the fault from the transceiver based on each estimated value, preferably as a mean of the estimated values;
- the fault localization system comprises at least two transceivers forming respectively a first transceiver and a second transceiver, the controller being configured to measure a time difference between a first emission time and a second reception time, the first emission time corresponding to the time at which the first transceiver radiates the corresponding probe electromagnetic wave, the second reception time corresponding to the time at which the second transceiver receives the response electromagnetic wave corresponding to the probe electromagnetic wave radiated by the first transceiver, the controller being configured to determine that the fault is inside an area between the first transceiver and the second transceiver if a duration $(t_{e,1} - t_{r,2} - \tau_s)$ is equal to a predetermined reference duration $t_{ref}$, and that the fault is outside the area between the first transceiver and the second transceiver if the duration $(t_{e,1} - t_{r,2} - \tau_s)$ is higher than the reference duration $t_{ref}$, wherein $t_{e,1}$ is the first emission time, $t_{e,2}$ is the second reception time, $t_{ref}$ is equal to L/v, L is a distance between the first transceiver and the second transceiver, and v is a propagation speed of the probe electromagnetic wave and the response electromagnetic wave in an environment between the first transceiver and the second transceiver;

- the fault localization system comprises at least two transceivers forming respectively a first transceiver and a second transceiver, the controller being configured to determine a first time difference corresponding to the time difference between the emission time and the reception time corresponding to the first transceiver, and a second time difference corresponding to the time difference between the emission time and the reception time corresponding to the second transceiver, the controller being further configured to determine a distance of the fault from the first transceiver as:

$$D = L\frac{\left(\Delta t_1 - \tau_{s,1}\right)}{\left(\Delta t_1 - \tau_{s,1}\right) + \left(\Delta t_2 - \tau_{s,2}\right)}$$

where D is the distance of the fault from the first transceiver;
L is a distance between the first transceiver and the second transceiver;
$\Delta t_1$ is the first time difference;
$\tau_{s,1}$ is a duration of the probe signal corresponding to the first transceiver;
$\Delta t_2$ is the second time difference; and
$\tau_{s,2}$ is a duration of the probe signal corresponding to the second transceiver;

- the fault localization system comprises at least two transceivers forming respectively a first transceiver and a second transceiver, the controller being configured to determine a first time difference corresponding to the time difference between the emission time and the reception time corresponding to the first transceiver, the controller being further configured to determine a distance of the fault from the first transceiver as:

$$D = L \frac{\left(\Delta t_1 - \tau_{s,1}\right)}{T_{1,2}}$$

where D is the distance of the fault from the first transceiver;

L is a distance between the first transceiver and the second transceiver;

$\Delta t_1$ is the first time difference;

$\tau_{s,1}$ is a duration of the probe signal corresponding to the first transceiver; and

$T_{1,2}$ is a predetermined time duration associated to the first transceiver and the second transceiver;

- the fault localization system comprises at least three transceivers, the controller being configured to determine:

  • for each transceiver, a distance of the fault from the transceiver based on the time difference between the emission time and the reception time corresponding to the transceiver; and
  • a position in space of the fault using a 3D triangulation technique, based on the determined distance between each transceiver and the fault.

The invention also relates to an assembly comprising a gas-insulated switchgear and at least one fault localization system as defined above, each transceiver of each fault localization system being arranged within an enclosure of the gas-insulated switchgear which houses an insulating gas.

According to an advantageous aspect of the invention, the assembly includes the following feature: the controller is configured so that the emission time belongs to a time interval of predetermined duration around an instant for which a voltage of a conductor arranged within an enclosure of the gas-insulated switchgear is equal to 0V.

The invention also relates to a fault localization system method for locating a fault in a gas-insulated switchgear according to claim 12, at least one transceiver being arranged within the gas-insulated switchgear, each transceiver being configured to output a detection signal corresponding to a received electromagnetic wave, preferably generated by the fault, the fault localization method comprising, for each transceiver, the following steps:

- computing a time reversed signal by performing time reversal based on the corresponding detection signal;
- inputting, to the transceiver, an associated probe signal that is dependent on the corresponding time reversed signal, to cause the transceiver to radiate, at an emission time, a probe electromagnetic wave based on the corresponding probe signal, and to output a response signal associated to a response electromagnetic wave, received at a reception time and corresponding to a response of the environment of the transceiver to the probe electromagnetic wave; and

- determining information relating to the location of the fault based on a time difference between the emission time and the reception time.

## BRIEF DESCRIPTION OF THE DRAWINGS

The invention will be better understood with the attached figures, in which:

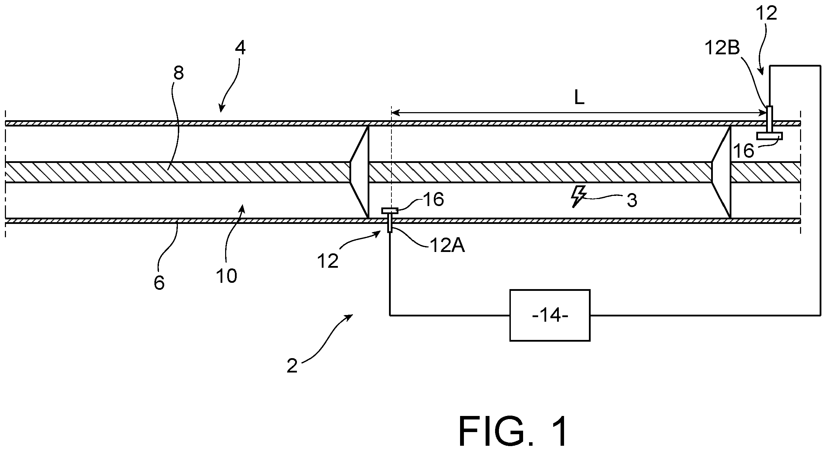

- figure 1 is a schematic view of showing a detail of an assembly comprising a gas-insulated switchgear and a fault localization system according to the invention, each transceiver of the fault localization system being arranged in an enclosure of the gas-insulated switchgear housing an insulating gas;

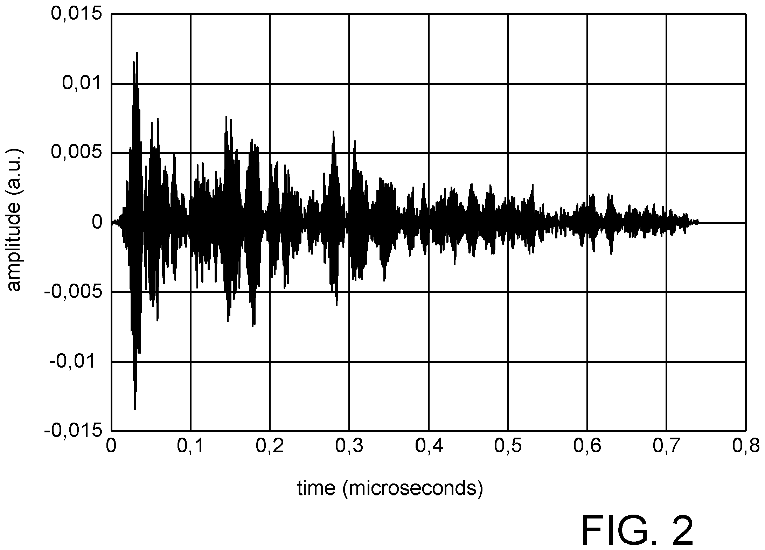

- figure 2 is a graph showing the evolution over time of a detection signal output from a transceiver of the fault localization system of figure 1, said detection signal corresponding to a received electromagnetic wave generated by a partial discharge occurring in the gas-insulated switchgear; and

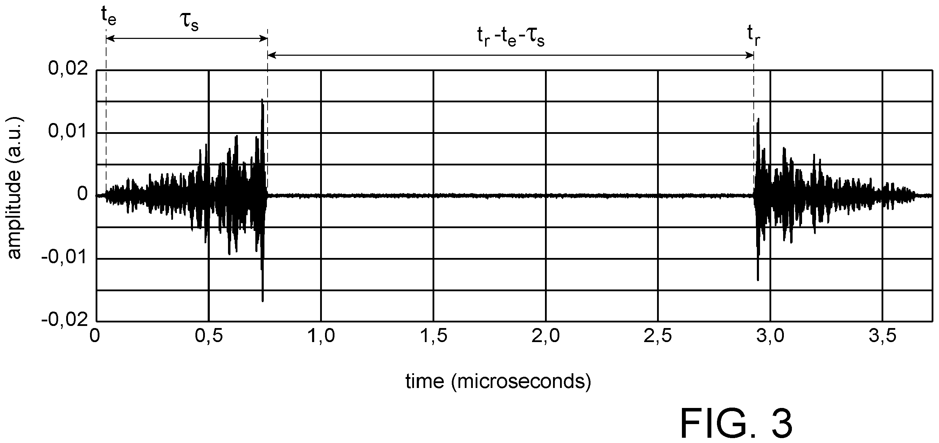

- figure 3 is a graph showing the evolution over time of a probe signal and of a response signal, the probe signal being computed by the fault localization system of figure 1 based on the detection signal of figure 2, and the response signal corresponding to a response of the gas-insulated switchgear of figure 1 to said detection signal.

## DESCRIPTION OF PREFERED EMBODIMENTS

A fault localization system 2 is shown on figure 1. The fault localization system 2 is configured to locate a fault 3, and more specifically a partial discharge, occurring within a gas-insulated switchgear 4.

The gas-insulated switchgear 4 comprises an enclosure 6 which houses conductors 8 and an insulating gas 10, said insulating gas 10 providing electrical insulation between the conductors 8 and the enclosure 6.

During operation of the gas-insulated switchgear 4, a fault 3 (also referred to as "partial discharge") may occur. Such partial discharge generates electromagnetic waves, hereinafter referred to as "fault-generated electromagnetic waves", generally having a frequency in the ultra-high frequency band.

The fault localization system 2 comprises at least one transceiver 12 and a controller 14 connected to each transceiver 12.

Each transceiver 12 is configured to output an electrical signal corresponding to an electromagnetic wave received by said transceiver 12 and having a frequency within a predetermined frequency range, preferably the ultra-high frequency band. In particular, the electromagnetic wave received by said transceiver 12 is a fault-generated electromagnetic wave.

Each transceiver 12 is also configured to radiate an electromagnetic wave corresponding to an electrical signal input to said transceiver 12.

For instance, the transceiver 12 comprises a first antenna (not shown) for receiving electromagnetic waves and outputting corresponding electrical signals, and a second antenna (not shown) for receiving electrical signals and radiating corresponding electromagnetic waves.

Alternatively, the transceiver 12 comprises a single antenna 16 for both receiving and radiating electromagnetic waves. In this case, the transceiver further comprises a known electronic device (for instance, a PIN diode) for allowing electric signal to be input to and output from a same port of the antenna 16.

As shown on figure 1, each transceiver 12 is arranged within the enclosure 6 of the gas-insulated switchgear 4, in order to receive the electromagnetic wave generated by a partial discharge occurring in the insulating gas 10 of said gas-insulated switchgear 4 and to output a corresponding detection signal.

An example of such a detection signal is shown on figure 2. Such a signal comprises echoes due to reflection, refraction and diffraction of the fault-generated electromagnetic wave during its path from the location of the corresponding fault to the transceiver 12.

Each transceiver 12 is also configured to radiate a probe electromagnetic wave and to receive a corresponding response electromagnetic wave. The probe electromagnetic wave and the response electromagnetic wave are described below.

More specifically, the transceiver 12 is configured to radiate the probe electromagnetic wave based on a corresponding probe signal input to said transceiver 12. The transceiver 12 is also configured to output a response signal based on the corresponding response electromagnetic wave

The controller 14 is configured to receive the detection signal output from each transceiver 12.

Advantageously, a bandpass filter is arranged between the controller 14 and each transceiver 12. This allows for a rejection of noise that is not related to the fault-generated electromagnetic wave to be processed. Such noise may be due to other partial discharges occurring while the gas-insulated switchgear 4 is energized.

Alternatively, the controller 14 is configured to perform numerical filtering on the detection signal to achieve such noise rejection.

The controller 14 is further configured to locate the fault based on the detection signal output from each transceiver 12.

More specifically, for each transceiver 12, the controller 14 is configured to compute a time reversed signal by performing time reversal based on the corresponding detection signal. More precisely, the time reversed signal is a time reversed version of the detection signal.

Time reversal procedures are known to the person skilled in signal processing.

The controller 14 is also configured to input, to the transceiver 12, a corresponding probe signal that is dependent on its respective time reversed signal.

For instance, for a given transceiver 12, the controller 14 is configured to generate the respective probe signal by amplifying the time reversed signal computed based on the corresponding detection signal output from said transceiver 12.

It is advantageous to generate the probe signal by amplifying the time reversed signal. Indeed, this increases signal-to-noise ratio in the corresponding response signal. Moreover, by properly adjusting such amplification, blind transceivers (that is to say transceivers for which the power level of the fault-generated electromagnetic wave was too low to allow detection, compared to the corresponding noise level) may become sensitive. This allows for improved accuracy in the determination of the location of the fault.

An example of such a probe signal, having a duration $\tau_s$, is shown on figure 3.

Moreover, for each transceiver 12, the controller 14 is configured to input the respective probe signal to said transceiver 12, so that the transceiver 12 radiates, at an emission time $t_e$ (see figure 3), a corresponding electromagnetic wave. More precisely, the electromagnetic wave radiated by the transceiver 12 based on the corresponding probe signal is the aforementioned probe electromagnetic wave.

Advantageously, the emission time $t_e$ is chosen so as to belong to a time interval of predetermined duration around an instant at which the voltage of the conductors 8 reaches 0V (volt), that is to say a time interval of predetermined duration around an instant at which a phase of the alternating voltage of the conductors 8 is equal to 0° or 180°.

This is advantageous, because the occurrence of partial discharges is significantly lowered when the voltage of the conductors 8 is near 0V. As a result, external noise resulting from partial discharges is reduced.

Such feature can be achieved because, for a gas-insulated switchgear included in a 50Hz (hertz) power grid, the voltage has a period of 20ms (millisecond), which is several orders of magnitude longer that the duration $\tau_s$ of the probe signal (typically a few tens of nanoseconds to a few hundred nanoseconds).

Such a probe electromagnetic wave propagates within the gas-insulated switchgear 4. Because the probe signal is generated based on a time reversed version of the associated detection signal, the probe electromagnetic wave focuses at the same location as the fault which has generated the corresponding fault-generated electromagnetic wave received by the same transceiver 12. Then, from the location of the fault, the probe electromagnetic wave propagates as the aforementioned response electromagnetic wave. As such, the response electromagnetic wave can be seen as a response of the environment of the transceiver 12 (that is, of the gas-insulated switchgear 4) to the probe electromagnetic wave.

Such a response electromagnetic wave follows the same path as the fault-generated electromagnetic wave. More specifically, the response electromagnetic wave reaches, at a reception time $t_r$ (see figure 3), the transceiver 12 which has radiated the corresponding probe electromagnetic wave.

The controller 14 is further configured to receive the response signal corresponding to the response electromagnetic wave received by the transceiver 12, and to determine the reception time $t_r$ by analyzing the response signal. More specifically, the controller 14 is configured to identify a triggering front of the response signal, the reception time $t_r$ being a time of reception of the triggering front. A triggering front is generally a part of the response signal that is associated to a predetermined part of the probe signal.

As a non-limiting example, the reception time $t_r$ corresponds to an instant for which the amplitude of the response signal reaches a predetermined amplitude threshold. Alternatively, the reception time $t_r$ corresponds to an instant at which a predetermined frequency first appears in the response signal. As an alternative, the reception time $t_r$ corresponds to an instant at which a time-reversed version of a predetermined part of the probe signal appears in the response signal.

The controller 14 is further configured to determine information relating to the location of the fault based on a time difference between the emission time $t_e$ and the reception time $t_r$.

More specifically, the controller 14 is configured to determine a distance D of the fault from a given transceiver 12 as:

$$D = \frac{v}{2}\left(t_r - t_e - \tau_s\right) \quad (1)$$

wherein v is a propagation speed of the probe electromagnetic wave and the response electromagnetic wave in the environment of the transceiver 12.

By "duration $\tau_s$ of the probe signal", it is meant, in the context of the present invention, a duration between the emission time $t_e$, i.e. the time at which the transceiver 12 starts radiating the probe electromagnetic wave, and a time at which the transceiver 12 radiates the probe electromagnetic wave based on a part of the probe signal that corresponds to a triggering front in the corresponding response signal.

In other words, the term $(t_r - t_e - \tau_s)$ corresponds to the duration between the reception of a triggering front and the prior emission of the corresponding part of the probe signal.

The propagation speed is generally expressed as:

$$v = c\sqrt{1 - \frac{f_c}{f}} \quad (2)$$

where c is the speed of light in the insulating gas 10;
f is a frequency of the probe electromagnetic wave and the response electromagnetic wave; and
$f_c$ is a critical frequency of a given mode, dependent on the geometrical characteristics of the gas-insulated switchgear 4.

Advantageously, to determine which part of a probe signal is to be considered as corresponding to a triggering front, the controller 14 is configured to compute several probe signals based on truncated versions of increasing length of the detection signal, each starting at the same point. The controller 14 is further configured to monitor, for each of the computed probe signals, the amplitude (or the energy, or the power) of the respective response signal.

In this case, the controller 14 is configured to consider, as the part of the probe signal that corresponds to a triggering front, the end of the shortest probe signal that maximizes the amplitude (or the energy, or the power) of the response signal.

This is due to the fact that the probe electromagnetic wave refocuses at its maximum amplitude when the duration of the corresponding time reversed signal is long enough to include all the necessary temporal features for maximum spatial and time focusing.

The operation of the fault localization system 2 will now be disclosed.

Each transceiver 12 of the fault localization system 2 is arranged within the enclosure 6 of the gas-insulated switchgear 4.

When a fault, such as a partial discharge, occurs in the insulating gas 10 of the gas-insulated switchgear 4, said fault generates a corresponding electromagnetic wave which propagates within the gas-insulated switchgear 4.

When the fault-generated electromagnetic wave reaches a transceiver 12, said transceiver 12 outputs, to the controller 14, a corresponding detection signal.

The controller 14 performs time reversal on the detection signal to compute a corresponding time reversed signal. Then, the controller 14 generates a probe signal based on the computed time reversed signal.

Then, the controller 14 inputs the probe signal to the transceiver 12, and the transceiver 12 radiates, at the emission time $t_e$, the corresponding electromagnetic wave.

The probe electromagnetic wave propagates within the gas-insulated switchgear 4, and focuses at the same location as the fault which has generated the fault-generated electromagnetic wave received by said transceiver 12.

Then, from the location of the fault, the probe electromagnetic wave propagates, as the response electromagnetic wave, within the gas-insulated switchgear 4, and reaches said transceiver 12 at a reception time $t_r$, which causes the transceiver 12 to output, to the controller 14, the corresponding response signal.

Then, the controller 14 determines information relating to the location of the fault based on the time difference between the emission time $t_e$ and the reception time $t_r$.

Advantageously, the fault localization system 2 is configured to perform determination of the location of the fault 3 several successive times. This reduces risks of triggering pollution that are due to errors in the identification of the triggering front, which entail errors in the determination of the reception time $t_r$.

As mentioned above, the controller 14 is configured to perform time reversal based on a detection signal by computing a time reversed version of said detection signal.

Alternatively, for any given transceiver 12, the controller 14 is configured to perform the time reversal based on the corresponding detection signal by first generating an intermediate signal. More precisely, the controller 14 is configured to generate the intermediate signal by amplifying a predetermined frequency of the detection signal and/or modulating a coda on the predetermined frequency of the detection signal. Moreover, the controller 14 is configured to then compute the time reversed signal as a time reversed version of the generated intermediate signal.

In this case, the controller 14 is preferably configured to determine the triggering front as the part of the response signal which first has the predetermined frequency: the reception time $t_r$ is a time at which the predetermined frequency is first detected in the response signal.

This is advantageous, because by amplifying a predetermined frequency, said predetermined frequency acts as a marker that allows reliable identification of the triggering front. Since the propagation speed is also frequency-dependent, as shown in formula (2), knowing the frequency associated to the reception time $t_r$ allows for a tuning of the value of the propagation speed, which improves reliability in the determination of the fault location.

For instance, to determine the evolution, overtime, of the spectral components exhibited by the response signal, the controller 14 is configured to determine the spectrum of the response signal over time by applying short-term Fourier transform or a wavelet transform to the response signal.

Alternatively, for any given transceiver 12, the controller 14 is configured to compute a plurality of time reversed signals, each depending on a corresponding intermediate signal generated based on a respective predetermined frequency. In other words, a plurality of probe signals are generated, each being associated to a respective predetermined frequency.

In this case, the controller 14 is further configured to estimate, for each predetermined frequency, a value of the distance of the fault 3 from the transceiver 12 based on the time difference between the emission time and the reception time corresponding to said predetermined frequency.

For instance, formula (1) is used for estimating each value of the distance of the fault 3 from the transceiver 12. In this case, for each estimation, the appropriate propagation speed is chosen depending on the corresponding predetermined frequency, by applying formula (2).

Preferably, the controller 14 is configured to input each probe signal to the transceiver 12 after the response signal corresponding to another probe signal has been received.

The controller 14 is also configured to determine the distance of the fault 3 from the transceiver 12 based on each estimated value, preferably as a mean of the estimated values.

Advantageously, as shown on figure 1, the fault localization system 2 comprises at least two transceivers 12 forming respectively a first transceiver 12A and a second transceiver 12B.

In this case, the controller 14 is preferably configured to determine a first time difference $\Delta t_1$ corresponding to the time difference between the emission time and the reception time corresponding to the first transceiver 12A, and a second time difference $\Delta t_2$ corresponding to the time difference between the emission time and the reception time corresponding to the second transceiver 12B. The first time difference $\Delta t_1$ and the second time difference $\Delta t_2$ are determined based on the same detection signal. In other words, the first time difference $\Delta t_1$ and the second time difference $\Delta t_2$ correspond to the same fault.

Moreover, the controller 14 is further configured to determine the distance D of the fault 3 from the first transceiver 12A as:

$$D = L \frac{\left(\Delta t_1 - \tau_{s,1}\right)}{\left(\Delta t_1 - \tau_{s,1}\right) + \left(\Delta t_2 - \tau_{s,2}\right)} \quad (3)$$

where L is a distance between the first transceiver 12A and the second transceiver 12B;
$\tau_{s,1}$ is a duration of the probe signal corresponding to the first transceiver 12A; and
$\tau_{s,2}$ is a duration of the probe signal corresponding to the second transceiver 12B.

This is advantageous in the case when the propagation speed is not precisely known. This is, for instance, the case when the gas-insulated switchgear 4 has a complex geometry that makes it difficult to determine the critical frequency $f_c$. On the contrary, the distance L between the first transceiver 12A and the second transceiver 12B is generally well known.

Alternatively or additionally, the controller 14 is configured to determine the distance D of the fault 3 from the first transceiver 12A as:

$$D = L\frac{\left(\Delta t_1 - \tau_{s,1}\right)}{T_{1,2}} \quad (4)$$

where $T_{1,2}$ is a predetermined time duration associated to the first transceiver 12A and the second transceiver 12B, and corresponding to the time required for a wave to propagate between the first transceiver 12A and the second transceiver 12B.

In this case, a calibration on the real path duration for an electromagnetic wave to cover the distance between the first transceiver 12A and the second transceiver 12B is used.

For instance, the predetermined time duration $T_{1,2}$ is determined as follows: first, a very short pulse, having a shape comparable to a Dirac function, is applied to the first transceiver 12A. As a result, the first transceiver 12A radiates a corresponding electromagnetic wave, which mimics a fault-generated electromagnetic wave. When said electromagnetic wave reaches the second transceiver 12B, the second transceiver 12B outputs a corresponding detection signal. By applying the fault localization method of the invention to said detection signal, the value of the term $(t_r - t_e - \tau_s)$ is determined. In this case, for each predetermined frequency, the value of the term $(t_r - t_e - \tau_s)$ corresponds to the predetermined time duration $T_{1,2}$. Here, $T_{1,2}$ corresponds to the back and forth duration of the wave path between the first transceiver 12A and the second transceiver 12B.

As another example, the predetermined time duration $T_{1,2}$ is determined by applying a very short pulse, having a shape comparable to a Dirac function, to the first transceiver 12A. As a result, the first transceiver 12A radiates an electromagnetic wave, which mimics a fault-generated electromagnetic wave. When said electromagnetic wave reaches the second transceiver 12B, the second transceiver 12B outputs a detection signal.

For each of predetermined frequency, the detection signal is processed to amplify said frequency, thus generating a processed signal. Then, the time difference between the emission time of the pulse and the time at which the predetermined frequency first appears in the processed signal corresponds to half the predetermined time duration $T_{1,2}$.

Alternatively, both of these methods are applied to ensure consistency between the results they provide.

For instance, the controller 14 is configured to determine the distance D using a combination of the results provided by formulas (3) and (4), such as the mean value of the results provided by formulas (3) and (4).

Moreover, if the fault localization system 2 comprises at least two transceivers 12A, 12B, the controller 14 is further advantageously configured to determine whether the fault is inside an area between the first transceiver 12A and the second transceiver 12B.

More precisely, in this case, when the first transceiver 12A radiates the corresponding probe electromagnetic wave at a first emission time $t_{e,1}$, the second transceiver 12B receives, at a second reception time $t_{r,2}$, the response electromagnetic wave corresponding to said probe electromagnetic wave radiated by the first transceiver 12A.

Advantageously, the controller 14 is configured to adjust the power of the probe signal to a level allowing for the response electromagnetic wave received by the second transceiver 12B to have a signal-to-noise ratio higher than a predetermined threshold.

The controller 14 is configured to measure a time difference between the first emission time $t_{e,1}$ and the second reception time $t_{r,2}$, and to determine:

-    that the fault is inside the area between the first transceiver 12A and the second transceiver 12B if a duration $(t_{r,2} - t_{e,1} - \tau_s)$ is equal to a predetermined reference duration $t_{ref}$; and

-    that the fault is outside the area between the first transceiver 12A and the second transceiver 12B if the duration $(t_{r,2} - t_{e,1} - \tau_s)$ is higher than the reference duration $t_{ref}$.

The reference duration $t_{ref}$ is equal to L/v, wherein:

L is a distance between the first transceiver 12A and the second transceiver 12B; and
v is a propagation speed of the probe electromagnetic wave and the response electromagnetic wave in an environment between the first transceiver 12A and the second transceiver 12B (that is, within the gas-insulated switchgear 4).

Advantageously, in the case where the controller 14 determines that the fault is outside the area between the first transceiver 12A and the second transceiver 12B, the controller is further configured to determine:

-    that the fault is closer to the first transceiver 12A if a duration $(t_{r,1} - t_{e,1})$ is shorter that a duration $(t_{r,2} - t_{e,1})$; and

-    that the fault is closer to the second transceiver 12B if the duration $(t_{r,1} - t_{e,1})$ is longer that the duration $(t_{r,2} - t_{e,1})$.

Here, $t_{r,1}$ is the time at which the first transceiver 12A receives the response electromagnetic wave corresponding to the probe electromagnetic wave radiated by said first transceiver 12A.

Advantageously, the fault localization system 2 comprises at least three transceivers 12. This is especially the case if the gas-insulated switchgear 4 comprises a transformer.

In this case, the controller 14 is configured to determine a position in space of the fault using a 3D triangulation technique, based on the computed distance D between the fault 3 and each transceiver 12. In this case, the fault is located at an intersection of three spheres, each sphere being centered at a respective transceiver 12. In this case, the radius of a given sphere is equal to the distance D computed for the corresponding transceiver 12. Such an intersection defines one or two points. In the latter case, one of these two case can generally be eliminated because it is located outside the enclosure 6.

**Claims**

1. A fault localization system (2) configured for locating a fault (3) in a gas-insulated switchgear (4), the fault localization system (2) comprising at least one transceiver (12, 12A, 12B) and a controller (14) connected to each transceiver (12, 12A, 12B),

   each transceiver (12, 12A, 12B) being configured to be arranged within the gas-insulated switchgear (4), each transceiver (12, 12A, 12B) being configured to output a detection signal corresponding to a received electromagnetic wave, generated by the fault (3);
   the controller (14) being configured, for each transceiver (12, 12A, 12B), to compute a time reversed signal by performing time reversal based on the corresponding detection signal, and to input, to the transceiver (12, 12A, 12B), an associated probe signal that is dependent on the corresponding time reversed signal;
   each transceiver (12, 12A, 12B) being further configured to radiate, at an emission time, a probe electromagnetic wave based on the corresponding probe signal, and to output a response signal associated to a response electromagnetic wave corresponding to a response of the environment of the transceiver (12, 12A, 12B) to the probe electromagnetic wave, and received at a reception time,
   the controller (14) being further configured to determine information relating to the location of the fault (3) based on a time difference between the emission time and the reception time.

2. The fault localization system (2) according to claim 1, wherein, the controller (14) is configured to determine a distance of the fault (3) from each transceiver (12, 12A, 12B) as:

$$D = \frac{v}{2}\left(t_r - t_e - \tau_s\right)$$

   wherein D is the distance of the fault (3) from the transceiver (12, 12A, 12B);
   v is a propagation speed of the probe electromagnetic wave and the response electromagnetic wave in the environment of the transceiver (12, 12A, 12B);
   $t_e$ is the emission time corresponding to the transceiver (12, 12A, 12B);
   $t_r$ is the reception time corresponding to the transceiver (12, 12A, 12B); and
   $\tau_s$ is a duration of the probe signal.

3. The fault localization system (2) according to claim 1 or 2, wherein, for each transceiver (12, 12A, 12B), the controller (14) is configured to generate the corresponding probe signal by amplifying the corresponding time reversed signal.

4. The fault localization system (2) according to any one of claims 1 to 3, wherein, for each transceiver (12, 12A, 12B), in order to perform time reversal based on the corresponding detection signal, the controller (14) is configured:

   - to generate an intermediate signal by amplifying a predetermined frequency of the detection signal and/or modulating a coda on the predetermined frequency of the detection signal; and
   - to compute the time reversed signal as a time reversed version of the generated intermediate signal,

   the controller (14) being further configured to determine the reception time as a time at which the predetermined frequency is first detected in the response signal.

5. The fault localization system (2) according to claim 4, wherein, for each transceiver (12, 12A, 12B), the controller (14) is configured to compute a plurality of time reversed signals, each depending on a corresponding intermediate signal generated based on a respective predetermined frequency,

   the controller (14) being further configured to estimate, for each predetermined frequency, a value of the distance of the fault (3) from the transceiver (12, 12A, 12B) based on the time difference between the emission time and the reception time corresponding to the predetermined frequency,

the controller (14) being also configured to determine the distance of the fault (3) from the transceiver (12, 12A, 12B) based on each estimated value, preferably as a mean of the estimated values.

6. The fault localization system (2) according to any one of claims claim 1 to 5, comprising at least two transceivers (12, 12A, 12B) forming respectively a first transceiver (12A) and a second transceiver (12B),

the controller (14) being configured to measure a time difference between a first emission time and a second reception time,
the first emission time corresponding to the time at which the first transceiver (12A) radiates the corresponding probe electromagnetic wave,
the second reception time corresponding to the time at which the second transceiver (12B) receives the response electromagnetic wave corresponding to the probe electromagnetic wave radiated by the first transceiver (12A),
the controller (14) being configured to determine that the fault (3) is inside an area between the first transceiver (12A) and the second transceiver (12B) if a duration $(t_{e,1} - t_{r,2} - \tau_s)$ is equal to a predetermined reference duration $t_{ref}$, and that the fault (3) is outside the area between the first transceiver (12A) and the second transceiver (12B) if the duration $(t_{e,1} - t_{r,2} - \tau_s)$ is higher than the reference duration $t_{ref}$,
wherein $t_{e,1}$ is the first emission time;
$t_{e,2}$ is the second reception time;
$t_{ref}$ is equal to L/v;
L is a distance between the first transceiver (12A) and the second transceiver (12B); and
v is a propagation speed of the probe electromagnetic wave and the response electromagnetic wave in an environment between the first transceiver (12A) and the second transceiver (12B).

7. The fault localization system (2) according to any one of claims claim 1 to 6, comprising at least two transceivers (12, 12A, 12B) forming respectively a first transceiver (12A) and a second transceiver (12B),

the controller (14) being configured to determine a first time difference corresponding to the time difference between the emission time and the reception time corresponding to the first transceiver (12A), and a second time difference corresponding to the time difference between the emission time and the reception time corresponding to the second transceiver (12B),
the controller (14) being further configured to determine a distance of the fault (3) from the first transceiver (12A) as:

$$D = L\frac{\left(\Delta t_1 - \tau_{s,1}\right)}{\left(\Delta t_1 - \tau_{s,1}\right) + \left(\Delta t_2 - \tau_{s,2}\right)}$$

where D is the distance of the fault (3) from the first transceiver (12A);
L is a distance between the first transceiver (12A) and the second transceiver (12B);
$\Delta t_1$ is the first time difference;
$\tau_{s,1}$ is a duration of the probe signal corresponding to the first transceiver (12A);
$\Delta t_2$ is the second time difference; and
$\tau_{s,2}$ is a duration of the probe signal corresponding to the second transceiver (12B).

8. The fault localization system (2) according to any one of claims claim 1 to 7, comprising at least two transceivers (12, 12A, 12B) forming respectively a first transceiver (12A) and a second transceiver (12B),

the controller (14) being configured to determine a first time difference corresponding to the time difference between the emission time and the reception time corresponding to the first transceiver (12A),
the controller (14) being further configured to determine a distance of the fault (3) from the first transceiver (12A) as:

$$D = L\frac{\left(\Delta t_1 - \tau_{s,1}\right)}{T_{1,2}}$$

where D is the distance of the fault (3) from the first transceiver (12A);
L is a distance between the first transceiver (12A) and the second transceiver (12B);
$\Delta t_1$ is the first time difference;
$\tau_{s,1}$ is a duration of the probe signal corresponding to the first transceiver (12A); and
$T_{1,2}$ is a predetermined time duration associated to the first transceiver (12A) and the second transceiver (12B).

9. The fault localization system (2) according to any one of claims claim 1 to 8, comprising at least three transceivers (12), the controller (14) being configured to determine:

- for each transceiver (12), a distance of the fault (3) from the transceiver (12) based on the time difference between the emission time and the reception time corresponding to the transceiver (12); and

   - a position in space of the fault (3) using a 3D triangulation technique, based on the determined distance between each transceiver (12) and the fault (3).

10. An assembly comprising a gas-insulated switchgear (4) and at least one fault localization system (2) according to any one of claims 1 to 9, each transceiver (12, 12A, 12B) of each fault localization system (2) being arranged within an enclosure (6) of the gas-insulated switchgear (4) which houses an insulating gas (10).

11. The assembly according to claim 10, wherein the controller (14) is configured so that the emission time belongs to a time interval of predetermined duration around an instant for which a voltage of a conductor (8) arranged within an enclosure (6) of the gas-insulated switchgear (4) is equal to 0V.

12. A fault localization method for locating a fault (3) in a gas-insulated switchgear (4), at least one transceiver (12, 12A, 12B) being arranged within the gas-insulated switchgear (4), each transceiver (12, 12A, 12B) being configured to output a detection signal corresponding to a received electromagnetic wave, generated by the fault (3),

   the fault localization method comprising, for each transceiver (12, 12A, 12B), the following steps:

      - computing a time reversed signal by performing time reversal based on the corresponding detection signal;

      - inputting, to the transceiver (12, 12A, 12B), an associated probe signal that is dependent on the corresponding time reversed signal, to cause the transceiver (12, 12A, 12B) to radiate, at an emission time ($t_e$), a probe electromagnetic wave based on the corresponding probe signal, and to output a response signal associated to a response electromagnetic wave, received at a reception time ($t_r$) and corresponding to a response of the environment of the transceiver (12, 12A, 12B) to the probe electromagnetic wave; and

      - determining information relating to the location of the fault (3) based on a time difference between the emission time ($t_e$) and the reception time ($t_r$).

**Patentansprüche**

1. Fehlerlokalisierungssystem (2), das zum Lokalisieren eines Fehlers (3) in einer gasisolierten Schaltanlage (4) konfiguriert ist, wobei das Fehlerlokalisierungssystem (2) mindestens einen Transceiver (12, 12A, 12B) und eine Steuereinheit (14) umfasst, die mit jedem Transceiver (12, 12A, 12B) verbunden ist,

   wobei jeder Transceiver (12, 12A, 12B) so konfiguriert ist, dass er innerhalb der gasisolierten Schaltanlage (4) angeordnet ist, wobei jeder Transceiver (12, 12A, 12B) so konfiguriert ist, dass er ein Detektionssignal ausgibt, das einer empfangenen elektromagnetischen Welle entspricht, die von dem Fehler (3) erzeugt wurde; wobei die Steuereinheit (14) für jeden Transceiver (12, 12A, 12B) so konfiguriert ist, dass sie ein zeitlich umgekehrtes Signal berechnet, indem sie eine Zeitumkehr auf Grundlage des entsprechenden Detektionssignals durchführt, und dass sie in den Transceiver (12, 12A, 12B) ein zugeordnetes Sondensignal eingibt, das von dem entsprechenden zeitlich umgekehrten Signal abhängig ist; wobei jeder Transceiver (12, 12A, 12B) weiter so konfiguriert ist, dass er zu einer Sendezeit eine elektromagnetische Sondenwelle auf Grundlage des entsprechenden Sondensignals ausstrahlt und ein Antwortsignal ausgibt, das einer elektromagnetischen Antwortwelle zugeordnet ist, die einer Antwort der Umgebung des Transceivers (12, 12A, 12B) auf die elektromagnetische Sondenwelle entspricht, und zu einer Empfangszeit empfangen wird, wobei die Steuereinheit (14) weiter so konfiguriert ist, dass sie Informationen über den Ort des Fehlers (3) auf Grundlage einer Zeitdifferenz zwischen der Sendezeit und der Empfangszeit bestimmt.

2. Fehlerlokalisierungssystem (2) nach Anspruch 1, wobei die Steuereinheit (14) so konfiguriert ist, dass sie eine Entfernung des Fehlers (3) von jedem Transceiver (12, 12A, 12B) wie folgt bestimmt:

$$D = \frac{v}{2}(t_r - t_e - \tau_s)$$

   wobei D die Entfernung des Fehlers (3) von dem Transceiver (12, 12A, 12B) ist; v eine Ausbreitungsgeschwindigkeit der elektromagnetischen Sondenwelle und der elektromagnetischen Antwortwelle in der Umgebung des Transceivers (12, 12A, 12B) ist; $t_e$ die Sendezeit ist, die dem Transceiver (12, 12A, 12B) entspricht; $t_r$ die Empfangszeit ist, die dem Transceiver (12, 12A, 12B) entspricht; und $\tau_s$ eine Dauer des Sondensignals ist.

3. Fehlerlokalisierungssystem (2) nach Anspruch 1 oder 2, wobei für jeden Transceiver (12, 12A, 12B) die Steuereinheit (14) so konfiguriert ist, dass sie das entsprechende Sondensignal durch Verstärkung des entsprechenden zeitlich umgekehrten Signals erzeugt.

4. Fehlerlokalisierungssystem (2) nach einem der Ansprüche 1 bis 3, wobei für jeden Transceiver (12, 12A, 12B), um auf Grundlage des entsprechenden Detektionssignals eine Zeitumkehr durchzuführen, die Steuereinheit (14) konfiguriert ist:

- zum Erzeugen eines Zwischensignals durch Verstärken einer vorbestimmten Frequenz des Detektionssignals und/oder Modulieren einer Coda auf die vorbestimmte Frequenz des Detektionssignals; und
- zum Berechnen des zeitlich umgekehrten Signals als eine zeitlich umgekehrte Version des erzeugten Zwischensignals,

wobei die Steuereinheit (14) weiter so konfiguriert ist, dass sie die Empfangszeit als eine Zeit bestimmt, zu der die vorbestimmte Frequenz erstmals im Antwortsignal detektiert wird.

5. Fehlerlokalisierungssystem (2) nach Anspruch 4, wobei für jeden Transceiver (12, 12A, 12B) die Steuereinheit (14) so konfiguriert ist, dass sie eine Vielzahl von zeitlich umgekehrten Signalen berechnet, die jeweils von einem entsprechenden Zwischensignal abhängen, das auf Grundlage einer jeweiligen vorbestimmten Frequenz erzeugt wird,

wobei die Steuereinheit (14) weiter so konfiguriert ist, dass sie für jede vorbestimmte Frequenz einen Wert der Entfernung des Fehlers (3) von dem Transceiver (12, 12A, 12B) auf Grundlage der Zeitdifferenz zwischen der Sendezeit und der Empfangszeit entsprechend der vorbestimmten Frequenz schätzt,
wobei die Steuereinheit (14) auch so konfiguriert ist, dass sie die Entfernung des Fehlers (3) von dem Transceiver (12, 12A, 12B) auf Grundlage jedes Schätzwertes, vorzugsweise als ein Mittelwert der Schätzwerte, bestimmt.

6. Fehlerlokalisierungssystem (2) nach einem der Ansprüche 1 bis 5, umfassend mindestens zwei Transceiver (12, 12A, 12B), die jeweils einen ersten Transceiver (12A) und einen zweiten Transceiver (12B) bilden,

wobei die Steuereinheit (14) so konfiguriert ist, dass sie eine Zeitdifferenz zwischen einer ersten Sendezeit und einer zweiten Empfangszeit misst,
wobei die erste Sendezeit der Zeit entspricht, zu der der erste Transceiver (12A) die entsprechende elektromagnetische Sondenwelle ausstrahlt,
wobei die zweite Empfangszeit der Zeit entspricht, zu der der zweite Transceiver (12B) die elektromagnetische Antwortwelle empfängt, die der von dem ersten Transceiver (12A) ausgestrahlten elektromagnetischen Sondenwelle entspricht,
wobei die Steuereinheit (14) so konfiguriert ist, dass sie bestimmt, dass der Fehler (3) innerhalb eines Bereichs zwischen dem ersten Transceiver (12A) und dem zweiten Transceiver (12B) liegt, wenn eine Dauer ($t_{e,1} - t_{r,2} - \tau_s$) gleich einer vorbestimmten Referenzdauer $t_{ref}$ ist, und dass der Fehler (3) außerhalb des Bereichs zwischen dem ersten Transceiver (12A) und dem zweiten Transceiver (12B) liegt, wenn die Dauer ($t_{e,1} - t_{r,2} - \tau_s$) größer als die Referenzdauer $t_{ref}$ ist,
wobei $t_{e,1}$ die erste Sendezeit ist;
$t_{e,2}$ die zweite Empfangszeit ist,
$t_{ref}$ gleich L/v ist;
L eine Entfernung zwischen dem ersten Transceiver (12A) und dem zweiten Transceiver (12B) ist; und
v eine Ausbreitungsgeschwindigkeit der elektromagnetischen Sondenwelle und der elektromagnetischen Antwortwelle in einer Umgebung zwischen dem ersten Transceiver (12A) und dem zweiten Transceiver (12B) ist.

7. Fehlerlokalisierungssystem (2) nach einem der Ansprüche 1 bis 6, umfassend mindestens zwei Transceiver (12, 12A, 12B), die jeweils einen ersten Transceiver (12A) und einen zweiten Transceiver (12B) bilden,

wobei die Steuereinheit (14) so konfiguriert ist, dass sie eine erste Zeitdifferenz entsprechend der Zeitdifferenz zwischen der Sendezeit und der Empfangszeit entsprechend dem ersten Transceiver (12A) und eine zweite Zeitdifferenz entsprechend der Zeitdifferenz zwischen der Sendezeit und der Empfangszeit entsprechend dem zweiten Transceiver (12B) bestimmt,
wobei die Steuereinheit (14) weiter so konfiguriert ist, dass sie eine Entfernung des Fehlers (3) von dem ersten Transceiver (12A) wie folgt bestimmt:

$$D = L \frac{(\Delta t_1 - \tau_{s,1})}{(\Delta t_1 - \tau_{s,1}) + (\Delta t_2 - \tau_{s,2})}$$

wobei D die Entfernung des Fehlers (3) von dem ersten Transceiver (12A) ist;
L eine Entfernung zwischen dem ersten Transceiver (12A) und dem zweiten Transceiver (12B)

ist;

$\Delta t_1$ die erste Zeitdifferenz ist;

$\tau_{s,1}$ eine Dauer des Sondensignals entsprechend dem ersten Transceiver (12A) ist;

$\Delta t_2$ die zweite Zeitdifferenz ist; und

$\tau_{s,2}$ eine Dauer des Sondensignals entsprechend dem zweiten Transceiver (12B) ist.

8. Fehlerlokalisierungssystem (2) nach einem der Ansprüche 1 bis 7, umfassend mindestens zwei Transceiver (12, 12A, 12B), die jeweils einen ersten Transceiver (12A) und einen zweiten Transceiver (12B) bilden,

> wobei die Steuereinheit (14) so konfiguriert ist, dass sie eine erste Zeitdifferenz entsprechend der Zeitdifferenz zwischen der Sendezeit und der Empfangszeit entsprechend dem ersten Transceiver (12A) bestimmt,
> wobei die Steuereinheit (14) weiter so konfiguriert ist, dass sie eine Entfernung des Fehlers (3) von dem ersten Transceiver (12A) wie folgt bestimmt:

$$D = L \frac{(\Delta t_1 - \tau_{s,1})}{T_{1,2}}$$

> wobei D die Entfernung des Fehlers (3) von dem ersten Transceiver (12A) ist;
> L eine Entfernung zwischen dem ersten Transceiver (12A) und dem zweiten Transceiver (12B) ist;
> $\Delta t_1$ die erste Zeitdifferenz ist;
> $\tau_{s,1}$ eine Dauer des Sondensignals entsprechend dem ersten Transceiver (12A) ist; und
> $T_{1,2}$ eine vorbestimmte Zeitdauer ist, die dem ersten Transceiver (12A) und dem zweiten Transceiver (12B) zugeordnet ist.

9. Fehlerlokalisierungssystem (2) nach einem der Ansprüche 1 bis 8, umfassend mindestens drei Transceiver (12), wobei die Steuereinheit (14) so konfiguriert ist, dass sie Folgendes bestimmt:

> - für jeden Transceiver (12) eine Entfernung des Fehlers (3) von dem Transceiver (12) auf Grundlage der Zeitdifferenz zwischen der Sendezeit und der Empfangszeit entsprechend dem Transceiver (12); und
> - eine Position im Raum des Fehlers (3) unter Verwendung einer 3D-Triangulationstechnik, auf Grundlage der bestimmten Entfernung zwischen jedem Transceiver (12) und dem Fehler (3).

10. Anordnung, umfassend eine gasisolierte Schaltanlage (4) und mindestens ein Fehlerlokalisierungssystem (2) nach einem der Ansprüche 1 bis 9, wobei jeder Transceiver (12, 12A, 12B) jedes Fehlerlokalisierungssystems (2) innerhalb eines Gehäuses (6) der gasisolierten Schaltanlage (4) angeordnet ist, das ein Isoliergas (10) aufnimmt.

11. Anordnung nach Anspruch 10, wobei die Steuereinheit (14) so konfiguriert ist, dass die Sendezeit zu einem Zeitintervall von vorbestimmter Dauer um einen Zeitpunkt gehört, für den eine Spannung eines innerhalb eines Gehäuses (6) der gasisolierten Schaltanlage (4) angeordneten Leiters (8) gleich 0 V ist.

12. Fehlerlokalisierungsverfahren zum Lokalisieren eines Fehlers (3) in einer gasisolierten Schaltanlage (4), wobei mindestens ein Transceiver (12, 12A, 12B) innerhalb der gasisolierten Schaltanlage (4) angeordnet ist, wobei jeder Transceiver (12, 12A, 12B) so konfiguriert ist, dass er ein Detektionssignal ausgibt, das einer empfangenen elektromagnetischen Welle entspricht, die von dem Fehler (3) erzeugt wurde,

wobei das Fehlerlokalisierungsverfahren für jeden Transceiver (12, 12A, 12B) die folgenden Schritte umfasst:

> - Berechnen eines zeitlich umgekehrten Signals durch Ausführen einer Zeitumkehr auf Grundlage des entsprechenden Detektionssignals;
> - Eingeben, in den Transceiver (12, 12A, 12B), eines zugeordneten Sondensignals, das von dem entsprechenden zeitlich umgekehrten Signal abhängt, um den Transceiver (12, 12A, 12B) zu veranlassen, zu einer Sendezeit ($t_e$) eine elektromagnetische Sondenwelle auf Grundlage des entsprechenden Sondensignals auszustrahlen und ein Antwortsignal auszugeben, das einer elektromagnetischen Antwortwelle zugeordnet ist, die zu einer Empfangszeit ($t_r$) empfangen wird und einer Antwort der Umgebung des Transceivers (12, 12A, 12B) auf die elektromagnetische Sondenwelle entspricht; und
> - Bestimmen von Informationen über den Ort des Fehlers (3) auf Grundlage einer Zeitdifferenz zwischen der Sendezeit ($t_e$) und der Empfangszeit ($t_r$).

**Revendications**

1. Système de localisation de défaut (2) configuré pour localiser un défaut (3) dans un appareillage de commutation à isolation gazeuse (4), le système de localisation de défaut (2) comprenant au moins un émetteur-récepteur (12, 12A, 12B) et un dispositif de commande (14) raccordé à chaque émetteur-récepteur (12, 12A, 12B),

chaque émetteur-récepteur (12, 12A, 12B) étant configuré pour être disposé à l'intérieur de l'appareillage de commutation à isolation gazeuse (4), chaque émetteur-récepteur (12, 12A, 12B) étant configuré pour délivrer un signal de détection correspondant à une onde électromagnétique reçue, générée par le défaut (3) ;

le dispositif de commande (14) étant configuré, pour chaque émetteur-récepteur (12, 12A, 12B), pour calculer un signal inversé dans le temps en effectuant une inversion du temps sur la base du signal de détection correspondant, et pour entrer, dans l'émetteur-récepteur (12, 12A, 12B), un signal de sonde associé qui dépend du signal inversé dans le temps correspondant ;

chaque émetteur-récepteur (12, 12A, 12B) étant en outre configuré pour émettre, à un moment d'émission, une onde électromagnétique de sonde sur la base du signal de sonde correspondant, et pour délivrer un signal de réponse associé à une onde électromagnétique de réponse correspondant à une réponse de l'environnement de l'émetteur-récepteur (12, 12A, 12B) à l'onde électromagnétique de sonde, et reçue à un moment de réception,

le dispositif de commande (14) étant en outre configuré pour déterminer des informations relatives à l'emplacement du défaut (3) sur la base d'une différence de temps entre le moment d'émission et le moment de réception.

2.　Système de localisation de défaut (2) selon la revendication 1, dans lequel le dispositif de commande (14) est configuré pour déterminer une distance entre le défaut (3) et chaque émetteur-récepteur (12, 12A, 12B) comme :

$$D = \frac{v}{2}(t_r - t_e - \tau_s)$$

dans lequel D est la distance entre le défaut (3) et l'émetteur-récepteur (12, 12A, 12B) ;

v est une vitesse de propagation de l'onde électromagnétique de sonde et de l'onde électromagnétique de réponse dans l'environnement de l'émetteur-récepteur (12, 12A, 12B) ;

$t_e$ est le moment d'émission correspondant à l'émetteur-récepteur (12, 12A, 12B) ;

$t_r$ est le moment de réception correspondant à l'émetteur-récepteur (12, 12A, 12B) ; et

$\tau_s$ est une durée du signal de sonde.

3.　Système de localisation de défaut (2) selon la revendication 1 ou 2, dans lequel, pour chaque émetteur-récepteur (12, 12A, 12B), le dispositif de commande (14) est configuré pour générer le signal de sonde correspondant en amplifiant le signal inversé dans le temps correspondant.

4.　Système de localisation de défaut (2) selon l'une quelconque des revendications 1 à 3, dans lequel, pour chaque émetteur-récepteur (12, 12A, 12B), afin d'effectuer une inversion du temps sur la base du signal de détection correspondant, le dispositif de commande (14) est configuré pour :

- générer un signal intermédiaire en amplifiant une fréquence prédéterminée du signal de détection et/ou moduler une coda sur la fréquence prédéterminée du signal de détection ; et
- calculer le signal inversé dans le temps comme une version inversée dans le temps du signal intermédiaire généré,

le dispositif de commande (14) étant en outre configuré pour déterminer le moment de réception comme un moment auquel la fréquence prédéterminée est détectée pour la première fois dans le signal de réponse.

5.　Système de localisation de défaut (2) selon la revendication 4, dans lequel, pour chaque émetteur-récepteur (12, 12A, 12B), le dispositif de commande (14) est configuré pour calculer une pluralité de signaux inversés dans le temps, chacun dépendant d'un signal intermédiaire correspondant généré sur la base d'une fréquence prédéterminée respective,

le dispositif de commande (14) étant en outre configuré pour estimer, pour chaque fréquence prédéterminée, une valeur de la distance entre le défaut (3) et l'émetteur-récepteur (12, 12A, 12B) sur la base de la différence de temps entre le moment d'émission et le moment de réception correspondant à la fréquence prédéterminée, le dispositif de commande (14) étant également configuré pour déterminer la distance entre le défaut (3) et l'émetteur-récepteur (12, 12A, 12B) sur la base de chaque valeur estimée, de préférence en tant que moyenne des valeurs estimées.

6.　Système de localisation de défaut (2) selon l'une quelconque des revendications 1 à 5, comprenant au moins deux émetteurs-récepteurs (12, 12A, 12B) formant respectivement un premier émetteur-récepteur (12A) et un second émetteur-récepteur (12B),

le dispositif de commande (14) étant configuré pour mesurer une différence de temps entre un premier moment d'émission et un second moment de réception,

le premier moment d'émission correspondant au moment auquel le premier émetteur-récepteur (12A) émet l'onde électromagnétique de sonde correspondante,

le second moment de réception correspondant au moment auquel le second émetteur-récepteur (12B) reçoit l'onde électromagnétique de réponse correspondant à l'onde électromagnétique de sonde émise par le premier émetteur-récepteur (12A),

le dispositif de commande (14) étant configuré pour déterminer que le défaut (3) se trouve à l'intérieur d'une zone entre le premier émetteur-récepteur (12A) et le second émetteur-récepteur (12B) si une durée ($t_{e,1} - t_{r,2} - \tau_s$) est égale à une durée de référence prédéterminée $t_{ref}$, et que le défaut (3) se trouve en dehors de la zone comprise entre le premier émetteur-récepteur (12A) et le second émetteur-récepteur (12B) si la durée ($t_{e,1} - t_{r,2} - \tau_s$) est supérieure à la durée de référence $t_{ref}$,

dans lequel $t_{e,1}$ est le premier moment d'émission ;

$t_{e,2}$ est le second moment de réception ;

$t_{ref}$ est égal à L/v ;

L est une distance entre le premier émetteur-récepteur (12A) et le second émetteur-récepteur (12B) ; et

v est une vitesse de propagation de l'onde électromagnétique de sonde et de l'onde électromagnétique de réponse dans un environnement situé entre le premier émetteur-récepteur (12A) et le second émetteur-récepteur (12B).

7. Système de localisation de défaut (2) selon l'une quelconque des revendications 1 à 6, comprenant au moins deux émetteurs-récepteurs (12, 12A, 12B) formant respectivement un premier émetteur-récepteur (12A) et un second émetteur-récepteur (12B),

le dispositif de commande (14) étant configuré pour déterminer une première différence de temps correspondant à la différence de temps entre le moment d'émission et le moment de réception correspondant au premier émetteur-récepteur (12A), et une seconde différence de temps correspondant à la différence de temps entre le moment d'émission et le moment de réception correspondant au second émetteur-récepteur (12B),

le dispositif de commande (14) étant en outre configuré pour déterminer une distance entre le défaut (3) et le premier émetteur-récepteur (12A) comme :

$$D = L \frac{(\Delta t_1 - \tau_{s,1})}{(\Delta t_1 - \tau_{s,1}) + (\Delta t_2 - \tau_{s,2})}$$

dans lequel D est la distance entre le défaut (3) et le premier émetteur-récepteur (12A) ;

L est une distance entre le premier émetteur-récepteur (12A) et le second émetteur-récepteur (12B) ;

$\Delta t_1$ est la première différence de temps ;

$\tau_{s,1}$ est une durée du signal de sonde correspondant au premier émetteur-récepteur (12A) ;

$\Delta t_2$ est la seconde différence de temps ; et

$\tau_{s,2}$ est une durée du signal de sonde correspondant au second émetteur-récepteur (12B).

8. Système de localisation de défaut (2) selon l'une quelconque des revendications 1 à 7, comprenant au moins deux émetteurs-récepteurs (12, 12A, 12B) formant respectivement un premier émetteur-récepteur (12A) et un second émetteur-récepteur (12B),

le dispositif de commande (14) étant configuré pour déterminer une première différence de temps correspondant à la différence de temps entre le moment d'émission et le moment de réception correspondant au premier émetteur-récepteur (12A),

le dispositif de commande (14) étant en outre configuré pour déterminer une distance entre le défaut (3) et le premier émetteur-récepteur (12A) comme :

$$D = L \frac{(\Delta t_1 - \tau_{s,1})}{T_{1,2}}$$

dans lequel D est la distance entre le défaut (3) et le premier émetteur-récepteur (12A) ;

L est une distance entre le premier émetteur-récepteur (12A) et le second émetteur-récepteur (12B) ;

$\Delta t_1$ est la première différence de temps ;

$\tau_{s,1}$ est une durée du signal de sonde correspondant au premier émetteur-récepteur (12A) ; et

$T_{1,2}$ est une durée prédéterminée associée au premier émetteur-récepteur (12A) et au second émetteur-récepteur (12B).

9. Système de localisation de défaut (2) selon l'une quelconque des revendications 1 à 8, comprenant au moins trois émetteurs-récepteurs (12), le dispositif de commande (14) étant configuré pour déterminer :

- pour chaque émetteur-récepteur (12), une distance entre le défaut (3) et l'émetteur-récepteur (12) sur la base de la différence de temps entre le moment d'émission et le moment de réception correspondant à l'émetteur-récepteur (12) ; et
- une position dans l'espace du défaut (3) à l'aide d'une technique de triangulation 3D, sur la base de la distance déterminée entre chaque émetteur-récepteur (12) et le défaut (3).

10. Ensemble comprenant un appareillage de commutation à isolation gazeuse (4) et au moins un système de localisation de défaut (2) selon l'une quelconque des revendications 1 à 9, chaque émetteur-récepteur (12, 12A, 12B) de chaque système de localisation de défaut (2) étant agencé à l'intérieur d'une enceinte (6) de l'appareillage de commutation à isolation gazeuse (4) qui abrite un gaz isolant (10).

11. Ensemble selon la revendication 10, dans lequel le dispositif de commande (14) est configuré de sorte que le moment d'émission appartienne à un intervalle de temps de durée prédéterminée autour d'un instant pendant lequel une tension d'un conducteur (8) disposé à l'intérieur d'une enceinte (6) de l'appareillage de commutation à isolation gazeuse (4) est égale à 0 V.

12. Procédé de localisation de défaut pour localiser un défaut (3) dans un appareillage de commutation à isolation gazeuse (4), au moins un émetteur-récepteur (12, 12A, 12B) étant disposé à l'intérieur de l'appareillage de commutation à isolation gazeuse (4), chaque émetteur-récepteur (12, 12A, 12B) étant configuré pour délivrer un signal de détection correspondant à une onde électromagnétique reçue, générée par le défaut (3),
le procédé de localisation de défaut comprenant, pour chaque émetteur-récepteur (12, 12A, 12B), les étapes suivantes :

- le calcul d'un signal inversé dans le temps en effectuant une inversion du temps sur la base du signal de détection correspondant ;
- l'entrée, dans l'émetteur-récepteur (12, 12A, 12B), d'un signal de sonde associé qui dépend du signal inversé dans le temps correspondant, pour amener l'émetteur-récepteur (12, 12A, 12B) à émettre, à un moment d'émission ($t_e$), une onde électromagnétique de sonde sur la base du signal de sonde correspondant, et à délivrer un signal de réponse associé à une onde électromagnétique de réponse, reçue à un moment de réception ($t_r$) et correspondant à une réponse de l'environnement de l'émetteur-récepteur (12, 12A, 12B) à l'onde électromagnétique de sonde ; et
- la détermination d'informations relatives à l'emplacement du défaut (3) sur la base d'une différence de temps entre le moment d'émission ($t_e$) et le moment de réception ($t_r$).

FIG. 1

FIG. 2

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014300370 A1

- US 6014083 A

**Non-patent literature cited in the description**

- **HE SHAO-YIN et al.** Norm Criteria in the Electromagnetic Time Reversal Technique for Fault Location in Transmission Lines. *IEEE TRANSACTIONS ON ELECTROMAGNETIC COMPATIBILITY,* 01 October 2018, vol. 60 (5), 1240-1248